# EUROPEAN PATENT SPECIFICATION

(11) **EP 0 901 610 B1**
(45) Date of publication and mention of the grant of the patent: **30.10.2002**
(21) Application number: 97923251.9
(22) Date of filing: 23.05.1997
(51) Int. Cl.: G01D 4/00, G01R 22/00, G01F 15/00

(54) **METERING SYSTEMS**
ZÄHLSYSTEME
SYSTEME DE COMPTAGE

(30) Priority: 24.05.1996 GB 9610962
(43) Date of publication of application: 17.03.1999
(73) Proprietor: Siemens Metering Limited, Oldbury, Bracknell, Berkshire, RG12 8FZ (GB)
(72) Inventor: LOE, Robert, Rivers, Newport, Shropshire TF10 8BU (GB); LEWIS, William, Mark, Albrighton, Shropshire WV7 3DS (GB)
(74) Representative: Allen, Derek
(86) International application number: GB9701422
(87) International publication number: WO97045704

(56) References cited:
- WO-A-90/00724
- GB-A- 2 208 955
- US-A- 4 087 858
- US-A- 4 777 354
- PATENT ABSTRACTS OF JAPAN vol. 95, no. 9, 31 October 1995 & JP 07 141564 A (RICOH ELEMEX CORP), 2 June 1995,
- PATENT ABSTRACTS OF JAPAN vol. 95, no. 11, 26 December 1995 & JP 07 210754 A (TOKYO GAS CO LTD), 11 August 1995,
- PATENT ABSTRACTS OF JAPAN vol. 15, no. 188 (P-1201), 15 May 1991 & JP 03 043894 A (TOHO GAS CO LTD)

## Description

This invention relates to metering systems for metering various services such as gas, electricity, water etc. which may be supplied by a utility to a consumer.

In general there are two types of meter, namely prepayment meters, whereby the consumer pays in advance for consumption of the service, and non-prepayment meters. For non-prepayment meters, the meter is read periodically, and the consumer is billed for consumption of the service over the preceding period. If a bill is not paid, the supply to the consumer may be cut off. In the case of gas this is generally done by attendance at the consumer's premises to operate a manual shut-off valve, and in the case of electricity this may also be done by remote activation of a cut-off switch in the meter for example. In contrast, in prepayment meters, the consumer pays in advance by loading the meter with credit, for example by inserting coins or, more recently, by inserting a smart card which has been loaded with credit purchased by a consumer at a remote point of sale. In such meters, a control unit stores a credit value indicative of consumption for which the consumer has paid in advance. If consumption exceeds the credit value, the meter automatically cuts off the supply. In the case of a gas meter, for example, the control unit activates an associated shut-off valve, and in the case of an electricity meter, the control unit simply activates a switch to disconnect the supply. The supply is restored by deactivating the cut-off means when the meter is loaded with further credit.

Prepayment meters thus offer a number of advantages over non-prepayment meters. Prepayment meters ensure that payment keeps pace with consumption and the consumer's account is kept up-to-date. The use of smart cards in prepayment systems also provides a convenient mechanism for communicating consumption data to the supplier since the meter reading can be loaded automatically to the card when inserted in the meter and then read at the point of sale when the card is presented to purchase credit.

At present, basic non-prepayment type meters can only be used in non-prepayment installations. To upgrade a non-prepayment installation to a prepayment installation, the basic meter must be replaced by one with a prepayment facility. This of course involves substantial expense to the supplier. Further, while present systems seek to ensure payment by cutting off the supply of the metered quantity, this can result in undue hardship to the consumer who may be denied essential services until arrangements for payment can be made.

US-A-4, 777,354 (Thomas) provides the system for controlling the supply the utility service such as electricity, gas, water and oil. The system includes one or more service supply control units for controlling the supply of the service to a consumer location of a predetermined time period. A deactivating device is connected to the supply control unit for effecting termination of the supply of the service upon expiry of the predetermined time period.

In view of the foregoing, and in consideration of expected changes to the energy supply industry following deregulation, it would be desirable to provide metering systems which are more efficient in terms of cost and flexibility while meeting the needs of both supplier and consumer.

According to one aspect of the present invention there is provided a metering system comprising:
a plurality of meters for generating consumption data indicative of consumption by a consumer of respective services, at least one of the meters including cut-off means for cutting off the supply to the consumer of the service metered thereby; and
control means for storing, for at least one of said services, a credit value indicative of consumption credited to the consumer for the associated service;
wherein the control means is arranged to receive said consumption data from each of the meters and to activate said cut-off means to cut-off said metered services at least for predetermined intervals if, for the service or a predetermined number of said services for which the control means stores a said credit value, use exceeds the credit value or values, characterised by the condition that at least one of said services remains available to the consumer, at least for the said predetermined intervals, even if for all the services for which the control means stores a said credit value, use exceeds the relevant credit value or values.

In accordance with the invention, therefore, the control means receives the consumption data from all meters in the system, and the cut-off means can be activated in accordance with various criteria depending on the particular arrangement of the system. This allows various advantages of prepayment-type systems to be achieved even though not all meters incorporate a cut-off facility. Even when only one of the meters includes cut-off means and only a single credit value for the service metered by that meter is stored in the control means, in effect implementing a prepayment system for the one service only, the control means still receives the consumption data from all meters. Reading of this data from the control means thus enables correct meter readings to be obtained for all meters in a single reading operation. This can be conveniently performed by output means of the control means which writes the data to a smart card which is used by the consumer to load credit for the service with the prepayment facility. Thus, in the course of normal use of the smart card by the consumer to update the credit value for the prepayment service, the card can also serve to communicate consumption data for all meters to the supplier. Of course, output means of the control means may be adapted for communication of the consumption data by other systems, preferably exploiting whatever system is employed for data communication as part of the normal operation of the prepayment system.

In other arrangements, the control means is arranged to store a said credit value for each of the metered services. Here, therefore, a prepayment system can be implemented for a plurality of services, eg. gas, electricity, water etc., even though not all of the meters may incorporate a supply cut-off facility. The consumption data from each meter is communicated to the control means which stores the credit value corresponding to consumption credited to the consumer for each of the services. The control means compares consumption of each service with the associated credit value and, if consumption exceeds credit for a predetermined number of the services, the cut-off means is activated. The said predetermined number may be one, in which case the cut-off means is activated if consumption of any service exceeds the associated credit value.
Alternatively, the cut-off means may only be activated if all, or say two out of three, credit values are exceeded. In all cases, the credit values may of course incorporate some tolerance as compared with the precise consumption for which the consumer has paid. For example, continued consumption for a predetermined time, or to a predetermined cost, over and above that for which the consumer has actually paid may be allowed for by the credit values. In any case, once the necessary condition occurs, the consumer's supply of at least one of the metered quantities is cut-off but not all for a continuous period. The supply which is disconnected may or may not be that (or one of those) for which consumption has exceeded credit, but payment can be ensured by withholding supply of one service until the further payment has been made for the service or services in respect of which credit has expired. Thus, a prepayment system can be implemented even if one or more of the meters does not incorporate a cut-off facility provided that such a facility is provided by at least one of the meters in the system. This enables a non-prepayment gas meter installation for example to be upgraded to a prepayment system without replacing the basic meter.

Where more than one of the meters includes cut-off means, the control means may activate one or more of the cut-off means if consumption exceeds credit for said predetermined number of metered services, but not all of the cut-off means for a continuous period. In some embodiments, the control means may be arranged selectively to activate the cut-off means of different meters. For example, different cut-off means may be activated at different times such that each supply is periodically cut-off and restored while at least one supply is cut-off at any time. Thus, through selective activation of the cut-off means, a multi-services utility can continue to provide essential services whilst still acting to ensure payment by interrupting one or more of the supplies.

The control means may be provided in the meter, or one of the meters, which has a cut-off facility. In this case, the or each other meter includes transmitter means for transmission of the consumption data to the control means, the control means including receiver means for reception of the consumption data. Where the control means is provided in one of the meters, and one or more of the other meters also includes cut-off means, the control means includes transmitter means for transmitting a control signal to activate the cut-off means, and the associated meter or meters include receiver means for reception of the control signal. The control means may, however, be provided separately of the meters in a remote unit, in which case the control means includes both transmitter means for transmitting cut-off control signals and receiver means for receiving the consumption data from the meters. Each meter then includes transmitter means for transmitting the consumption data to the control means, and those meters with a cut-off facility include receiver means for reception of the cut-off control signal.

Communication of the data and control signals between the meters and control means may be achieved in any convenient manner, eg. by transmission/reception of electrical or optical signals via hard-wired links, but in preferred embodiments the transmitter and receiver means are adapted for wireless communication. Similarly, the prepayment operation may be effected by remote communications with the control means, eg. by PSTN-based or radio or mains signalling systems, or the metering system may include user-operable input means associated with the control means for updating of the credit values. Preferably such user-operable input means comprises a smart card reader for loading the credit data from a smart card to the control means. As noted above, the communication system used for the prepayment operation can also be exploited for communication of meter readings to the supplier.

A further aspect of the present invention provides a metering method comprising:
metering the supply to a consumer of a plurality of services by means of respective meters for generating consumption data indicative of consumption use of the metered services, at least one of the meters including cut-off means for cutting off the supply to the consumer of the service metered thereby;
communicating the consumption data from each of the meters to control means
in the control means comparing the consumption data for at least one of said services with a credit value indicative of consumption credited to the consumer for the associated service; and
activating the cut-off means to cut-off said supply if, for the service or a predetermined number of said services for which the consumption data is compared with an associated credit value, consumption exceeds the associated credit value or values;
wherein at least one of said metered services is not cut-off, at least for the said predetermine intervals, even if, for all the services for which the control means stores a credit value, use exceeds the relevant credit value or values.

In general, where features are described herein with reference to an apparatus according to the invention, corresponding features may be provided in accordance with a method of the invention, and vice versa.

Embodiments of the invention will now be described, by way of example, with reference to the accompanying drawings in which:
Figure 1 is a simplified schematic of a metering system embodying the invention;
Figure 2 is a schematic block diagram illustrating the system of Figure 1 in more detail;
Figure 3 is a simplified schematic of a second metering system embodying the invention;
Figure 4 is a schematic block diagram illustrating elements of the system of Figure 3 in more detail; and
Figure 5 is a simplified schematic of a third metering system embodying the invention.

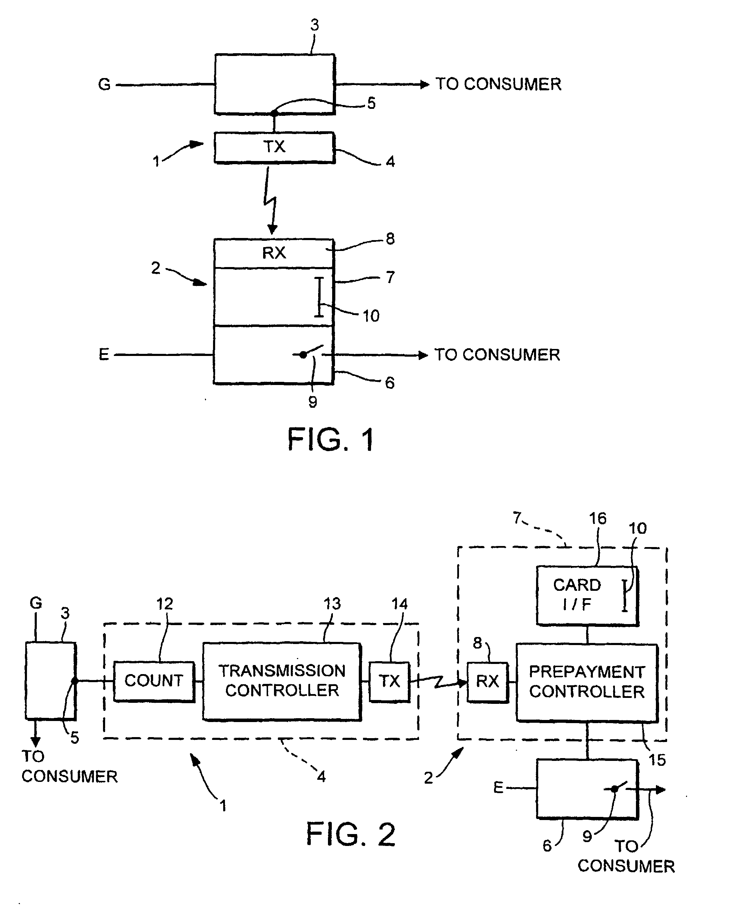

Figure 1 shows a first metering system comprising a gas meter, indicated generally at 1, and an electricity meter indicated generally at 2. The gas meter 1 comprises a basic U6 mechanical gas meter 3 with a transmitter unit 4 coupled to the standard R5 output 5 of the meter. The basic meter 3 operates in known manner to meter the supply of gas G to a consumer. An electrical pulse is derived at the R5 output 5 for each cubic foot of gas consumed. These pulses are detected by the transmitter unit 4.

The electricity meter 2 comprises the basic meter circuitry 6 with associated prepayment unit 7 and built-in receiver 8. The meter circuitry 6 monitors the consumption of electricity E in known manner and incorporates a cut-off switch 9 for cutting off the electricity supply to the consumer. The prepayment unit 7 is similar to that of a standard electricity prepayment meter in that the unit has a card slot 10 for insertion of the smart card (not shown) to load the meter with credit. Here, however, the prepayment unit 7 is arranged to load credit values for both gas and electricity consumption. Gas consumption data is transmitted by the transmitter unit 4 of the gas meter 1 and is received by the receiver 8 in the electricity meter. Based on this gas consumption data, and the electricity consumption data obtained directly from the meter circuitry 6, the prepayment unit monitors both gas and electricity consumption in relation to the respective pre-loaded gas and electricity credit values. If either gas or electricity consumption exceeds the associated credit value, the prepayment unit 7 activates the cut-off switch 9 to disconnect the electricity supply to the consumer.

Figure 2 shows the system of Figure 1 in more detail. The figure illustrates schematically the basic U6 meter 3 with the transmitter unit 4 connected to the R5 output socket. The transmitter unit 4 is preferably secured to the U6 meter 3 by suitable anti-tamper fixing means to inhibit unauthorised disconnection of the transmitter. The transmitter unit 4 includes a counter 12 which counts the pulses derived from the R5 output and supplies the count to a transmission controller 13 which in turn controls a transmitter 14.

The prepayment unit 7 of the electricity meter 2 comprises a prepayment controller 15 which is connected to the meter circuitry 6 and to the built-in receiver 8. The prepayment unit 7 also includes a smart card interface 16, also connected to the prepayment controller 15, for communication of data with a smart card (not shown) when inserted in the card slot 10 in use.

In operation, the consumer takes the smart card to a point of sale and pays in advance for desired amounts of gas and electricity consumption. Credit values indicating the gas and electricity consumption credited to the consumer are loaded onto the smart card at the point of sale, and the consumer then inserts the smart card into the card slot 10 of the electricity meter 2 on returning to the premises. The card is read by the card interface 16 and the credit values are supplied to the prepayment controller 15. The prepayment controller 15 stores these credit values after adjustment, if necessary, for any unused credit left over from the previous payment. While the smart card is inserted in the card reader, other data may be read from the card, eg. settings for the prepayment controller 15, and, as described further below, the prepayment controller also loads data onto the card, via the card interface 16, for communication to the supplier when the next transaction is made.

The prepayment controller 15 receives the electricity consumption data from the meter circuitry 6 and compares the consumption with that credited to the consumer as indicated by the prestored electricity credit value. The gas consumption data is communicated to the prepayment controller 15 periodically via the transmitter unit 4 and receiver 8. At predetermined intervals, for example of a few minutes, the transmission controller 13 loads the current count from the counter 12 and adds this to the previous count value stored in the transmission controller to obtain a current count indicative of the current gas consumption level. The counter 12 is then reset. The transmission controller 13 then activates the transmitter 14 to transmit the current gas consumption data to the prepayment unit 7 where the data is communicated to the prepayment controller 15 via the receiver 8. In addition to the gas consumption data, the transmission controller 13 may transmit other data such as the meter serial number (preprogrammed in the transmission controller 13), and status and security information. For example, the transmission controller 13 may be arranged to detect tampering with the unit and to transmit a security warning to set a warning flag in the controller if tampering is detected. Further, in this embodiment the transmitter unit is powered by battery (not shown) and the transmission controller 13 may be arranged to detect a battery-low condition and transmit a status warning to the controller with the consumption data.

The prepayment controller 15 thus receives the gas and electricity consumption data for comparison with the prestored credit values. In this embodiment, if either the gas consumption or the electricity consumption exceeds the corresponding credit value, the prepayment controller 15 transmits a control signal to the meter circuitry 6 to open the cut-off switch 9 and disconnect the electricity supply to the consumer. Further, where status and/or security data is transmitted by the gas meter 1, the prepayment controller 15 may be responsive to the status/security warning flags to activate the cut-off switch 9 if a warning condition is indicated. Alternatively, or in addition, this data may be communicated to the supplier as discussed further below.

When the smart card is next inserted in the prepayment unit 7 after further credit has been purchased by the consumer, the credit values are updated as previously described and the prepayment controller 15 transmits a control signal to the meter circuitry 6 whereby the switch 9 is closed and the electricity supply restored. The prepayment controller also loads to the card the current gas and electricity meter readings and other data such as identification (meter serial numbers etc.) status and security data to be communicated to the supplier when the card is next read. With regard to the meter readings, the prepayment controller 15 can of course monitor these by accumulating the gas and electricity consumption data with initial readings loaded via the smart card for example. Where the status/security warning flags have been set and are written to the smart card, these may be acknowledged at the point of sale by writing to the card and the acknowledgement detected by the prepayment controller 15 to reset the flags when the card is next read. Appropriate action can be taken by the supplier on receipt of the warning message, such as visiting the premises for maintenance/checking of equipment.

In the above embodiment, the transmitter unit 4 transmits the current gas consumption data periodically, the consumption data being updated for each transmission in accordance with the count indicated by the counter 12. Where such periodic transmission is employed, the prepayment controller 15 may be arranged to activate the cut-off switch 9 to cut-off the electricity supply if, after a predetermined time interval, no transmission has been received from the gas meter 1, for example due to failure of the transmitter unit 4. As an alternative to periodic transmission, the transmitter unit 4 may instead transmit after preprogrammed time-of-day windows if the unit incorporates a real time clock of sufficient accuracy. If the prepayment unit 7 is similarly provided with a real time clock, the prepayment controller 15 may activate the cut-off switch 9 if a transmission is not received at the expected time. Alternatively, the transmitter unit 4 may operate on a random or consumption driven basis. If transmission is consumption driven, the transmission controller 13 may 'time-out' after a predetermined interval if no transmission has been prompted. In this case, the transmitter 4 may re-transmit the consumption data for the last transmission to flag to the controller 15 that consumption has ceased. Such a warning flag may be communicated to the supplier as previously described for appropriate action to be taken.

As will be appreciated, the above described system enables a supplier of gas and electricity to implement a prepayment system for both services but without having to replace the gas meter by a prepayment meter. The system also permits electricity and gas accounts to be kept up-to-date, improving change of customer (and any possible change of supplier) procedures.

It will be apparent that various further modifications to the above system are possible. For example, a hard-wired link or other communications media may be employed for communication of data to the prepayment unit. Also, the meter configuration may be reversed where the gas meter is of the prepayment type, incorporating a cut-off valve, and the electricity meter is a non-prepayment meter with no cut-off switch. The prepayment controller 15 may of course be programmed to require both gas and electricity credit to be used up before activating the cut-off means. Further, although not shown in the figures, it will be appreciated that the prepayment unit may include a display or indicators for indicating various conditions/instructions to the user, eg. that credit of either quantity has expired and further payment should be attended to.

In the above embodiment, credit values for both gas and electricity are stored, and a prepayment system is implemented for both services, even though only the electricity meter incorporates a cut-off facility. However, a prepayment system could be implemented for electricity only. In this case, a single credit value for electricity is stored, electricity consumption is monitored as against this credit value, and the cut-off switch 9 activated when the credit has expired. The meter 2 then operates as a standard prepayment meter, with the exception that gas consumption data (and other data such as status/security data as described above) is still received from the gas meter 1 by the prepayment unit 7. This data can therefore be written to the smart card when inserted for the credit loading operation and communicated to the supplier as already described. Thus, the electricity prepayment operation is exploited as a convenient vehicle for communication of gas consumption data, allowing gas meter readings etc to be kept up-to-date without additional effort by the supplier or consumer.

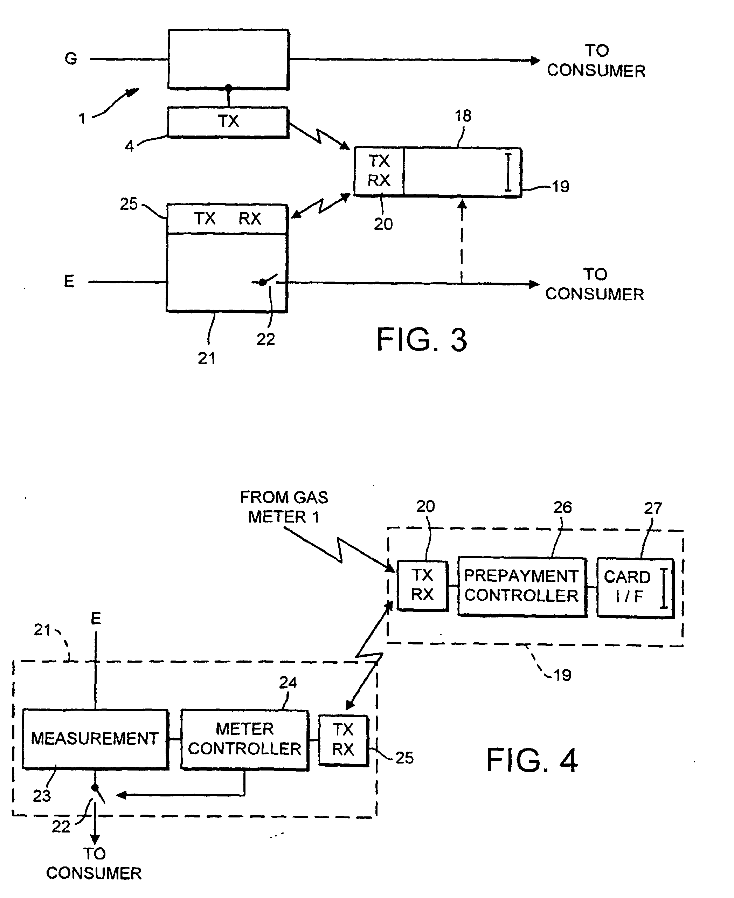

Figure 3 shows a further embodiment of a metering system in which the prepayment unit 18 is provided in a separate customer panel 19 with built-in transmitter and receiver unit 20. Here, the system includes a gas meter 1 with transmitter unit 4 as previously described with reference to Figures 1 and 2, and an electricity meter 21 with transmitter and receiver unit 25. The electricity meter 21 again includes a cut-off switch 22 for cutting off the electricity supplied to the consumer. In this embodiment, the customer panel 19 may be mounted at any convenient location within the premises. As indicated by the arrow in the figure, the customer panel 19 may be normally powered by the mains supply, but the unit includes a battery (not shown) which can be recharged from the mains supply to allow continued operation of the panel in the event that the electricity supply is disconnected.

A schematic block diagram of the electricity meter 21 and customer panel 19 is shown in Figure 4. The gas meter 1 is omitted from this figure since the structure and operation of this meter is as previously described with reference to Figures 1 and 2. As illustrated, the electricity meter 21 includes the usual measurement circuitry 23 which is connected to a meter controller 24 which records the consumption data. The meter controller 24 also controls operation of the cut-off switch 22 and the transmitter/receiver unit 25. The customer panel 19 incorporates the transmitter/receiver 20 and the prepayment unit 18 comprising prepayment controller 26 and card interface 27. Operation of this system is similar to that of the first embodiment except that, in this embodiment, the prepayment controller 26 and electricity meter 21 are adapted for remote communication via the transmitter/receiver units 20 and 25. The meter controller 24 periodically activates the transmitter 25 to transmit the consumption data, here the current meter reading, to the prepayment controller 26 via the receiver 20. Again, the transmission may include other data such as identification (eg. meter serial number), status and security data if desired. The prepayment controller 26 also receives the gas consumption data (plus identification/status/security data) from the gas meter 1 and monitors the gas and electricity consumption with respect to the corresponding credit values. If either gas or electricity consumption exceeds that credited to the consumer, the prepayment controller transmits a control signal to the electricity meter 21 via the transmitter 20. The control signal is received by the receiver 25 and communicated to the meter controller 24 which then opens the cut-off switch 22, thereby disconnecting the electricity supply. When further credit is loaded via the card interface 27 as previously described, the prepayment controller again transmits a control signal which is received by the meter controller 24 via receiver 25, and the switch 22 is closed to restore the electricity supply.

As in the case of the first embodiment, various alternative configurations to the embodiment of Figures 3 and 4 will be apparent. For example, a configuration is possible in which the gas meter includes a shut-off valve and appropriate control circuitry, but no cut-off switch is provided in the electricity meter. In this case, two-way communication (for consumption data and cut-off control signals) is provided between the gas meter and customer panel, and communication between the electricity meter and customer panel is one-way for transmission of consumption data. As before, other communications media could be employed, and again the cut-off condition may be that credit for both gas and electricity consumption has been used up. Alternatively the apparatus may implement a prepayment operation for only one of the services, and exploit the prepayment communication system simply to communicate consumption data (and related data if desired) for the other service to the supplier as described above.

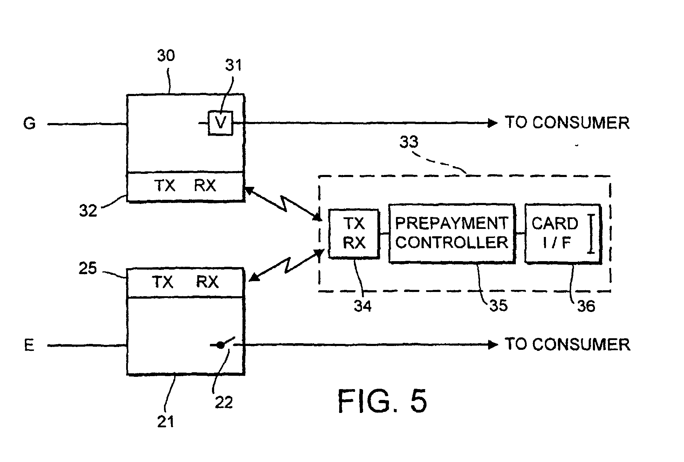

Figure 5 illustrates a further embodiment of the invention in which both the gas and electricity meters incorporate cut-off means. Here the electricity meter 21 is as described with reference to Figures 3 and 4 and includes the cut-off switch 22 and transmitter/receiver unit 25. In this embodiment, however, the gas meter 30 includes a shut-off valve 31 and appropriate control circuitry (not shown) together with transmitter/receiver unit 32. The gas meter 30 thus operates in an equivalent manner to the electricity meter 21 as already described, and is adapted for two-way communication with the customer panel 33 which again includes transmitter/receiver unit 34, prepayment controller 35, and card interface 36. In this embodiment, however, the prepayment controller 35 may be programmed to control interruption of the gas and electricity supplies in a number of different ways. For example, on detection of a cut-off condition (which may be that credit for either one, or both, of gas and electricity has been used up), the prepayment controller 35 may initially activate either one, or both, of the cut-off switch 22 and shut-off valve 31. Where both supplies are subject to being cut-off, the prepayment controller is operable to transmit control signals selectively to the gas and electricity meters to restore the respective supplies periodically for predetermined intervals. While the supplies may be restored together for the same interval, preferably the supplies are restored for different intervals so that at least one supply is cut off at all times. Where the controller 35 initially cuts off one supply, this may be restored, and the other supply cut off, after a given period, this process being repeated until input of further credit. Such selective activation of the cut-off means allows the supplier to continue to provide essential services, on political or social grounds, whilst acting to ensure payment by interruption of the suppliers until further payment is made.

As in the case of the first and second embodiments, various modifications to the embodiments of Figure 4 are of course possible. Further, while systems employing two meters, one gas and one electricity, have been described, it will be appreciated that the systems can readily be extended to incorporate further meters, including, for example, a water meter which may or may not incorporate a prepayment control valve. Various further changes and modifications may be made to the specific embodiments described above without departing from the scope of the invention as defined in the claims.

## Claims

1. A metering system comprising:-
a plurality of meters (1, 2) for generating data indicative of use by a consumer of respective metered services, at least one of the meters having an associated cut-off means (9,31) for cutting off the supply to the consumer of the service metered thereby; and
control means (15,26,35), common to the plurality of meters for storing, for at least one of said services, a prepaid credit value for the associated service;
wherein the control means is arranged to receive said data from each of the meters and to activate said cut-off means to cut-off at least one of said metered services at least for predetermined intervals if, for the service or a predetermined number of said services for which the control means stores a said credit value, use exceeds the credit value or values, and **characterised in that** at least one of said services remains available to the consumer at least for the said predetermined intervals, even if for all the services for which the control means (15) store a said credit value, use exceeds the relevant credit value or values.

2. A metering system as claimed in claim 1, wherein the control means includes means for outputting the data received from the meters for communication of said data to the service supplier.

3. A metering system as claimed in claim 1 or claim 2, wherein the control means is arranged to store, for each of at least one of said services, respective prepaid credit values.

4. A metering system as claimed in claim 3, wherein the control means (15) is arranged selectively to activate the cut-off (9) means of different meters (1, 2) after the credit value has been exceeded for said predetermined number of services.

5. A metering system is claimed in claim 4 wherein the control means is arranged to selectively activate the cut-off means of different meters after the credit value has been exceeded for said predetermined number of services.

6. A metering system as claimed in any preceding claim, wherein the control means is provided in said meter which has said associated cut-off means, wherein the or each other meter includes transmitter means for transmission of the said data to the control means, and wherein the control means includes receiver means for reception of said data.

7. A metering system as claimed in claim 6 when dependent on claim 4 or claim 5,
wherein the or each said other meter including cut-off means includes receiver means for receiving a control signal to activate said cut-off means, and wherein the control means includes transmitter means for transmission of said control signal.

8. A metering system as claimed in any preceding claim, wherein the control means is provided in a remote unit wherein each meter includes transmitter means for transmission of the said data to the control means, wherein the or each meter including cut-off means includes receiver means for receiving a control signal to activate said cut-off means, and wherein the control means includes transmitter means for transmission of said control signal and receiver means for reception of said consumption data.

9. A metering system as claimed in any one of claims 6 to 8, wherein said transmitter and receiver means are adapted for wireless communication.

10. A metering system as claimed in any preceding claim including user-operable input means associated with said control means for updating of the credit value or values.

11. A metering system as claimed in claim 10, wherein said input means comprises a smart card reader.

12. A metering system as claimed in any one of claims 1 to 9, wherein the control means (15) is arranged for reception of control data from a remote control station and to update said credit value or values in response to said control data.

13. A metering system as claimed in any preceding claim including a gas meter and an electricity meter.

14. A metering system as claimed in any preceding claim including a gas meter, an electricity meter and a water meter.

15. A metering system as claimed in claim 13 or claim 14 wherein at least the electricity meter includes said cut-off means.

16. A metering method comprising:
metering the supply to a consumer of a plurality of metered services by means of respective meters (1, 2) for generating data indicative of use of the metered services, at least one of the meters having an associated cut-off means (9,31) for cutting off the supply to the consumer of the service metered thereby;
communicating the said data from each of the meters to control means (15,26,35) common to the plurality of meters;
in the control means comparing the said data for at least one of said services with a prepaid credit value for the associated service; and
activating the cut-off means to cut-off at least one of said metered services for at least predetermined intervals if, for the service or a predetermined number of said services for which the said data is compared with a credit value or values, use exceeds the credit value or values and **characterised in that** at least one of the said metered services remains available to the consumer, at least for the said predetermined intervals, even if, for all the services for which the control means stores a credit value, use exceeds the relevant credit value or values.

17. A method according to claim 16, wherein the control means stores, for each of at least one of said services, respective prepaid credit values for the associated services.

## Patentansprüche

1. Zählsystem mit:
einer Vielzahl von Zählern (1, 2) zum Erzeugen von Daten, die die Nutzung svon jeweiligen gemessenen Diensten durch einen Verbraucher angeben, wobei zumindest einer der Zähler eine zugehörige Absperreinrichtung (9, 31) zum Absperren der Lieferung des durch diesen gemessenen Dienstes an den Verbraucher aufweist; und
einer Steuereinrichtung (15, 26, 35), die der Vielzahl von Zählern gemeinsam ist, zum Speichern eines vorausbezahlten Kreditwerts für den zugehörigen Dienst für zumindest einen der Dienste;
wobei die Steuereinrichtung angeordnet ist, um die Daten von jedem der Zähler zu empfangen und die Absperreinrichtung zu aktivieren, um zumindest einen der gemessenen Dienste zumindest für vorbestimmte Intervalle abzusperren, wenn für den Dienst oder eine vorbestimmte Anzahl der Dienste, für die die Steuereinrichtung einen Kreditwert speichert, die Nutzung den Kreditwert oder die Kreditwerte übersteigt, und **dadurch gekennzeichnet, daß** zumindest einer der Dienste für den Verbraucher zumindest für die vorbestimmten Intervalle verfügbar bleibt, selbst wenn für alle Dienste, für die die Steuereinrichtung (15) einen Kreditwert speichert, die Nutzung den relevanten Kreditwert oder die relevanten Kreditwerte übersteigt.

2. Zählsystem nach Anspruch 1, bei welchem die Steuereinrichtung eine Einrichtung zum Ausgeben der Daten, die von den Zählern empfangen werden, zur Übertragung der Daten zum Dienstlieferanten umfaßt.

3. Zählsystem nach Anspruch 1 oder Anspruch 2, bei welchem die Steuereinrichtung zum Speichern von jeweiligen vorausbezahlten Kreditwerten für jeden von zumindest einem der Dienste angeordnet ist.

4. Zählsystem nach Anspruch 3, bei welchem die Steuereinrichtung (15) angeordnet ist, um wahlweise die Absperreinrichtung (9) von verschiedenen Zählern (1, 2) zu aktivieren, nachdem der Kreditwert für die vorbestimmte Anzahl von Diensten überschritten wurde.

5. Zählsystem nach Anspruch 4, bei welchem die Steuereinrichtung angeordnet ist, um die Absperreinrichtung von verschiedenen Zählern wahlweise zu aktivieren, nachdem der Kreditwert für die vorbestimmte Anzahl von Diensten überschritten wurde.

6. Zählsystem nach einem vorangehenden Anspruch, bei welchem die Steuereinrichtung in dem Zähler vorgesehen ist, der die zugehörige Absperreinrichtung aufweist, wobei der oder jeder andere Zähler eine Sendereinrichtung zum Senden der Daten zur Steuereinrichtung umfaßt, und wobei die Steuereinrichtung eine Empfängereinrichtung zum Empfang der Daten umfaßt.

7. Zählsystem nach Anspruch 6 sofern auf Anspruch 4 oder Anspruch 5 zurückbezogen, bei welchem der oder jeder andere Zähler mit einer Absperreinrichtung eine Empfängereinrichtung zum Empfangen eines Steuersignals, um die Absperreinrichtung zu aktivieren, umfaßt und wobei die Steuereinrichtung eine Sendereinrichtung zum Senden des Steuersignals umfaßt.

8. Zählsystem nach einem vorangehenden Anspruch, bei welchem die Steuereinrichtung in einer entfernten Einheit vorgesehen ist, wobei jeder Zähler eine Sendereinrichtung zum Senden der Daten zur Steuereinrichtung umfaßt, wobei der oder jeder Zähler mit einer Absperreinrichtung eine Empfängereinrichtung zum Empfangen eines Steuersignals, um die Absperreinrichtung zu aktivieren, umfaßt und wobei die Steuereinrichtung eine Sendereinrichtung zum Senden des Steuersignals und eine Empfängereinrichtung zum Empfang der Verbrauchsdaten umfaßt.

9. Zählsystem nach einem der Ansprüche 6 bis 8, bei welchem die Senderund die Empfängereinrichtung für eine drahtlose Übertragung ausgelegt sind.

10. Zählsystem nach einem vorangehenden Anspruch mit einer vom Benutzer bedienbaren Eingabeeinrichtung, die zur Steuereinrichtung gehört, zum Aktualisieren des Kreditwerts oder der Kreditwerte.

11. Zählsystem nach Anspruch 10, bei welchem die Eingabeeinrichtung einen Chip-Karten-Leser umfaßt.

12. Zählsystem nach einem der Ansprüche 1 bis 9, bei welchem die Steuereinrichtung (15) zum Empfang von Steuerdaten von einer entfernten Steuerstation und zum Aktualisieren des Kreditwerts oder der Kreditwerte als Reaktion auf die Steuerdaten angeordnet ist.

13. Zählsystem nach einem vorangehenden Anspruch, einschließlich eines Gaszählers und eines Stromzählers.

14. Zählsystem nach einem vorangehenden Anspruch, einschließlich eines Gaszählers, eines Stromzählers und eines Wasserzählers.

15. Zählsystem nach Anspruch 13 oder Anspruch 14, bei welchem zumindest der Stromzähler die Absperreinrichtung umfaßt.

16. Zählverfahren, das folgendes umfaßt:
Messen der Lieferung einer Vielzahl von gemessenen Diensten zu einem Verbraucher mit Hilfe jeweiliger Zähler (1, 2) zum Erzeugen von Daten, die die Nutzung der gemessenen Dienste angeben, wobei zumindest einer der Zähler eine zugehörige Absperreinrichtung (9, 31) zum Absperren der Lieferung des durch diesen gemessenen Dienstes an den Verbraucher aufweist;
Übertragen der Daten von jedem der Zähler zu einer Steuereinrichtung (15, 26, 35), die der Vielzahl von Zählern gemeinsam ist;
in der Steuereinrichtung Vergleichen der Daten für zumindest einen der Dienste mit einem vorausbezahlten Kreditwert für den zugehörigen Dienst; und
Aktivieren der Absperreinrichtung, um zumindest einen der gemessenen Dienste für zumindest vorbestimmte Intervalle abzusperren, wenn für den Dienst oder eine vorbestimmte Anzähl der Dienste, für die die Daten mit einem Kreditwert oder Kreditwerten verglichen werten, die Nutzung den Kreditwert oder die Kreditwerte übersteigt, und **dadurch gekennzeichnet, daß** zumindest einer der gemessenen Dienste für den Verbraucher zumindest für die vorbestimmten Intervalle verfügbar bleibt, selbst wenn für alle Dienste, für die die Steuereinrichtung einen Kreditwert speichert, die Nutzung den relevanten Kreditwert oder die relevanten Kreditwerte übersteigt.

17. Verfahren nach Anspruch 16, bei welchem die Steuereinrichtung für jeden von zumindest einem der Dienste jeweilige vorausbezahlte Kreditwerte für die zugehörigen Dienste speichert.

## Revendications

1. Système de comptage comprenant :
une pluralité de compteurs (1, 2) pour produire des données indiquant l'utilisation par un consommateur de services comptés respectifs, l'un au moins des compteurs comportant un moyen de coupure associé (9, 31) pour interrompre la fourniture du service compté par celui-ci au consommateur ; et
un moyen de commande (15, 26, 35), commun à la pluralité de compteurs, pour mémoriser, pour au moins l'un desdits services, une valeur de crédit prépayée pour le service associé ;
dans lequel le moyen de commande est agencé pour recevoir lesdites données depuis chacun des compteurs et pour activer ledit moyen de coupure pour interrompre au moins l'un desdits services comptés au moins pendant des intervalles prédéterminés si, pour le service ou un nombre prédéterminé desdits services pour lesquels le moyen de commande mémorise une dite valeur de crédit, l'utilisation dépasse la valeur ou les valeurs de crédit, et **caractérisé en ce qu'**au moins l'un desdits services reste disponible pour le consommateur, au moins pendant lesdits intervalles prédéterminés, même si pour tous les services pour lesquels le moyen de commande (15) mémorise une dite valeur de crédit, l'utilisation dépasse la valeur ou les valeurs de crédit associées.

2. Système de comptage selon la revendication 1, dans lequel le moyen de commande comporte un moyen pour fournir en sortie les données reçues depuis les compteurs pour communications desdites données au fournisseur de service.

3. Système de comptage selon la revendication 1 ou la revendication 2, dans lequel le moyen de commande est agencé pour mémoriser, pour chacun parmi au moins l'un desdits services, des valeurs de crédit prépayées respectives.

4. Système de comptage selon la revendication 3, dans lequel le moyen de commande (15) est agencé de façon sélective pour activer les moyens de coupure (9) de différents compteurs (1, 2) après que la valeur de crédit a été dépassée pour ledit nombre de services prédéterminé.

5. Système de comptage selon la revendication 4, dans lequel le moyen de commande est agencé pour activer de façon sélective les moyens de coupure de différents compteurs après que la valeur de crédit a été dépassée pour ledit nombre de services prédéterminés.

6. Système de comptage selon l'une quelconque des revendications précédentes, dans lequel le moyen de commande est prévu dans ledit compteur qui comporte ledit moyen de coupure associé, dans lequel le compteur ou chaque autre compteur comporte un moyen émetteur pour transmettre lesdites données au moyen de commande et dans lequel le moyen de commande comporte un moyen récepteur pour recevoir lesdites données.

7. Système de comptage selon la revendication 6 lorsqu'elle dépend de la revendication 4 ou de la revendication 5, dans lequel le compteur ou chaque autre dit compteur comportant un moyen de coupure comporte un moyen récepteur pour recevoir un signal de commande pour activer ledit moyen de coupure et dans lequel le moyen de commande comporte un moyen émetteur pour transmettre ledit signal de commande.

8. Système de comptage selon l'une quelconque des revendications précédentes, dans lequel le moyen de commande est prévu dans un module distant dans lequel chaque compteur comporte un moyen émetteur pour transmissions desdites données au moyen de commande, dans lequel le ou chaque compteur comportant un moyen de coupure comporte un moyen récepteur pour recevoir un signal de commande pour activer ledit moyen de coupure et
dans lequel le moyen de commande comporte un moyen émetteur pour transmission dudit signal de commande et un moyen récepteur pour réception desdites données de consommation.

9. Système de comptage selon l'une quelconque des revendications 6 à 8, dans lequel lesdits moyens émetteur et récepteur sont adaptés pour une communication sans fil.

10. Système de comptage selon l'une quelconque des revendications précédentes, comportant un moyen d'entrée pouvant être actionné par l'utilisateur associé audit moyen de commande pour mettre à jour la valeur ou les valeurs de crédit.

11. Système de comptage selon la revendication 10, dans lequel ledit moyen d'entrée comprend un lecteur de carte à puce.

12. Système de comptage selon l'une quelconque des revendications 1 à 9, dans lequel le moyen de commande (15) est agencé pour recevoir les données de commande provenant d'une station de commande distante et pour mettre à jour ladite valeur ou lesdites valeurs de crédit en réponse auxdites données de commandes.

13. Système de comptage selon l'une quelconque des revendications précédentes, comportant un compteur à gaz et un compteur d'électricité.

14. Système de comptage selon l'une quelconque des revendications précédentes, comportant un compteur à gaz, un compteur d'électricité et un compteur d'eau.

15. Système de comptage selon la revendication 13 ou la revendication 14, dans lequel au moins le compteur d'électricité comporte ledit moyen de coupure.

16. Procédé de comptage comprenant:
le comptage de la fourniture à un consommateur d'une pluralité de services comptés au moyen de compteurs respectifs (1, 2) pour produire des données indiquant l'utilisation des services comptés, au moins l'un des compteurs comportant un moyen de coupure associé (9, 31) pour interrompre la fourniture au consommateur du service compté par celui-ci ;
la communication desdites données provenant de chacun des compteurs à un moyen de commande (15, 26, 35) commun à la pluralité de compteurs ;
dans le moyen de commande, la comparaison desdites données pour au moins l'un desdits services à une valeur de crédit prépayée pour le service associé ; et
l'activation du moyen de coupure pour interrompre au moins l'un desdits services comptés pendant au moins des intervalles prédéterminés si, pour le service ou un nombre prédéterminé desdits services pour lesquels lesdites données sont comparées à une valeur ou des valeurs de crédit, l'utilisation dépasse la valeur ou les valeurs de crédit ; et **caractérisé en ce qu'**au moins l'un desdits services comptés reste disponible pour le consommateur, au moins pendant lesdits intervalles prédéterminés, même si, pour tous les services pour lesquels le moyen de commande mémorise une valeur de crédit, l'utilisation dépasse la valeur ou les valeurs de crédit associées.

17. Procédé selon la revendication 16, dans lequel le moyen de commande mémorise, pour chacun parmi au moins l'un desdits services, des valeurs de crédit prépayées respectives pour les services associés.
